(19) Europäisches Patentamt
European Patent Office
Office européen des brevets

(11) **EP 4 390 423 B1**

(12) **EUROPEAN PATENT SPECIFICATION**

(45) Date of publication and mention
of the grant of the patent:
**30.07.2025 Bulletin 2025/31**

(21) Application number: **23160676.5**

(22) Date of filing: **08.03.2023**

(51) International Patent Classification (IPC):
*G01R 31/392* (2019.01)

(52) Cooperative Patent Classification (CPC):
**G01R 31/392;** G01R 31/389; Y02E 60/10

(54) **METHOD AND DEVICE FOR DETECTING BATTERY STATE OF HEALTH**

VERFAHREN UND VORRICHTUNG ZUR ERKENNUNG DES GESUNDHEITSZUSTANDS EINER BATTERIE

PROCÉDÉ ET DISPOSITIF DE DÉTECTION DE L'ÉTAT DE SANTÉ D'UNE BATTERIE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **21.12.2022 CN 202211645372**

(43) Date of publication of application:
**26.06.2024 Bulletin 2024/26**

(73) Proprietor: CALB Group Co., Ltd.
**Changzhou City, Jiangsu Province (CN)**

(72) Inventors:
• **GAO, Po**
**Changzhou City; Jiangsu Province (CN)**
• **LI, Kui**
**Changzhou City, Jiangsu Province (CN)**
• **MA, Ruijun**
**Changzhou City, Jiangsu Province (CN)**

(74) Representative: **Becker, Eberhard**
**Becker Kurig & Partner**
**Patentanwälte mbB**
**Bavariastraße 7**
**80336 München (DE)**

(56) References cited:
**CN-A- 113 945 302      CN-A- 115 356 640**

• **STIASZNY BARBARA ET AL: "Electrochemical characterization and post-mortem analysis of aged LiMn2O4-Li(Ni0.5Mn0.3Co0.2)O2/graphite lithium ion batteries. Part I: Cycle a", JOURNAL OF POWER SOURCES, ELSEVIER, AMSTERDAM, NL, vol. 251, 3 December 2013 (2013-12-03), pages 439 - 450, XP028807499, ISSN: 0378-7753, DOI: 10.1016/ J.JPOWSOUR.2013.11.080**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**BACKGROUND**

Technical Field

The disclosure relates to the technical field of batteries, and in particular, to a method and device for detecting the battery state of health.

Description of Related Art

The battery state of health reflects the gradual attenuation of actual capacity of a power battery along with the increase in the number of times the power battery is used. The detection of the battery state of health of the power battery is one of the core functions of the battery management system (BMS) and is of great significance to ensure the safe use of the battery and prolong the battery cycle life. CN 115 356 640 A discloses determining the characteristic value reflecting the health of any one of the battery cells in a battery.

**SUMMARY**

The disclosure provides a method and a device for detecting a battery state of health configured to detect the battery state of health of a power battery.
In the first aspect, an embodiment of the disclosure provides a method for detecting a battery state of health, and the method includes the following steps.
When an electrochemical impedance test is performed on a power battery and test data is obtained, distribution of relaxation times (DRT) processing is performed on the test data and a DRT spectrogram is obtained.
Peak parameters of at least some peaks among a plurality of peaks of the DRT spectrogram are determined. The peak parameters include a peak frequency and/or an integrated area of a peak.
Deviations of the determined peak parameters from peak parameters of corresponding peaks in a DRT spectrogram corresponding to a reference power battery are calculated.
Capacity loss rate corresponding to the calculated deviations is determined according to a corresponding relationship between a predetermined deviation and a predetermined capacity loss rate of each of the peaks.
The battery state of health of the power battery is determined according to the determined capacity loss rate.
In the second aspect, an embodiment of the disclosure further provides a device for detecting a battery state of health, and the device includes a memory and a processor.
The memory is configured to store a program instruction.
The processor is configured to call the program instruction stored in the memory and execute the following processes according to an obtained program.
When an electrochemical impedance test is performed on a power battery and test data is obtained, distribution of relaxation times (DRT) processing is performed on the test data and a DRT spectrogram is obtained.
Peak parameters of at least some peaks among a plurality of peaks of the DRT spectrogram are determined. The peak parameters include a peak frequency and/or an integrated area of a peak.
Deviations of the determined peak parameters from peak parameters of corresponding peaks in a DRT spectrogram corresponding to a reference power battery are calculated.
Capacity loss rate corresponding to the calculated deviations is determined according to a corresponding relationship between a predetermined deviation and a predetermined capacity loss rate of each of the peaks.
The battery state of health of the power battery is determined according to the determined capacity loss rate.
In the third aspect, an embodiment of the disclosure further provides a battery device including a power battery and a device as provided in the embodiments of the disclosure.
Beneficial effects provided by the disclosure include the following.
The embodiments of the disclosure provide a method and a device for detecting a battery state of health. When a DRT spectrum of a power battery is obtained, peak parameters are determined from peak information given by the DRT spectrum. A deviation is obtained by making a difference with a peak parameter of a corresponding peak in a reference power battery. Through the deviation, a corresponding capacity loss rate is found from a corresponding relationship between the deviation and the capacity loss rate of each peak. Based on the found capacity loss rate, the battery state of health is determined. In this way, the battery state of health of the power battery is quickly and accurately detected, and data reference is provided for the use of the power battery.

# EP 4 390 423 B1

## BRIEF DESCRIPTION OF THE DRAWINGS

For a better understanding of the disclosure, reference may be made to exemplary embodiments shown in the following drawings. The components in the drawings are not necessarily to scale and related elements may be omitted, or in some instances proportions may have been exaggerated, so as to emphasize and clearly illustrate the features described herein. In addition, related elements or components can be variously arranged, as known in the art. Further, in the drawings, like reference numerals designate same or like parts throughout the several views.

FIG. 1 is a flow chart of a method for detecting a battery state of health according to an embodiment of the disclosure.

FIG. 2 is a distribution of relaxation times (DRT) spectrogram according to an embodiment of the disclosure.

FIG. 3 is a DRT spectrogram corresponding to different capacity loss rates according to an embodiment of the disclosure.

FIG. 4 is a relationship curve between a deviation and a capacity loss rate according to an embodiment of the disclosure.

FIG. 5 is another relationship curve between a deviation and a capacity loss rate according to an embodiment of the disclosure.

FIG. 6 is a schematic structural view of a device for detecting the battery state of health according to an embodiment of the disclosure.

FIG. 7 is a schematic structural view of a battery device according to an embodiment of the disclosure.

## DESCRIPTION OF THE EMBODIMENTS

The technical solutions in the exemplary embodiments of the disclosure will be described clearly and explicitly in conjunction with the drawings in the exemplary embodiments of the disclosure. The description proposed herein is just the exemplary embodiments for the purpose of illustrations only, not intended to limit the scope of the disclosure, so it should be understood that and various modifications and variations could be made thereto without departing from the scope of the disclosure.

In the description of the present disclosure, unless otherwise specifically defined and limited, the terms "first", "second" and the like are only used for illustrative purposes and are not to be construed as expressing or implying a relative importance. The term "plurality" is two or more. The term "and/or" includes any and all combinations of one or more of the associated listed items.

In particular, a reference to "the" object or "a" and "an" object is intended to denote also one of a possible plurality of such objects. Unless otherwise defined or described, the terms "connect", "fix" should be broadly interpreted, for example, the term "connect" can be "fixedly connect", "detachably connect", "integrally connect", "electrically connect" or "signal connect". The term "connect" also can be "directly connect" or "indirectly connect via a medium". For the persons skilled in the art, the specific meanings of the abovementioned terms in the present disclosure can be understood according to the specific situation.

Further, in the description of the present disclosure, it should be understood that spatially relative terms, such as "above", "below" "inside", "outside" and the like, are described based on orientations illustrated in the figures, but are not intended to limit the exemplary embodiments of the present disclosure.

In the context, it should also be understood that when an element or features is provided "outside" or "inside" of another element(s), it can be directly provided "outside" or "inside" of the other element, or be indirectly provided "outside" or "inside" of the another element(s) by an intermediate element.

Specific implementation of a method and device for detecting a battery state of health provided by the embodiments of the disclosure is described in detail in the following paragraphs in combination with the accompanying drawings. Note that the described embodiments are merely part of the embodiments, rather then all of the embodiments, of the disclosure.

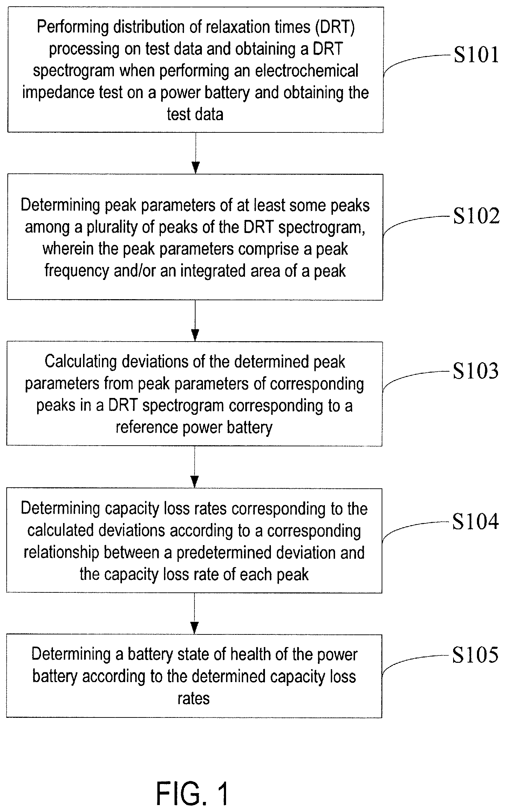

An embodiment of the disclosure provides a method for detecting a battery state of health, and as shown in FIG. 1, the method includes the following steps.

In S101, when an electrochemical impedance test is performed on a power battery and test data is obtained, DRT processing is performed on the test data, and a DRT spectrogram is obtained.

In some embodiments, the power battery may be, but not limited to a single battery, a battery apparatus, or a battery pack.

It should be understood that DRT stands for distribution of relaxation times.

In S102, peak parameters of at least some peaks among a plurality of peaks of the DRT spectrogram are determined, and the peak parameters include a peak frequency and/or an integrated area of a peak.

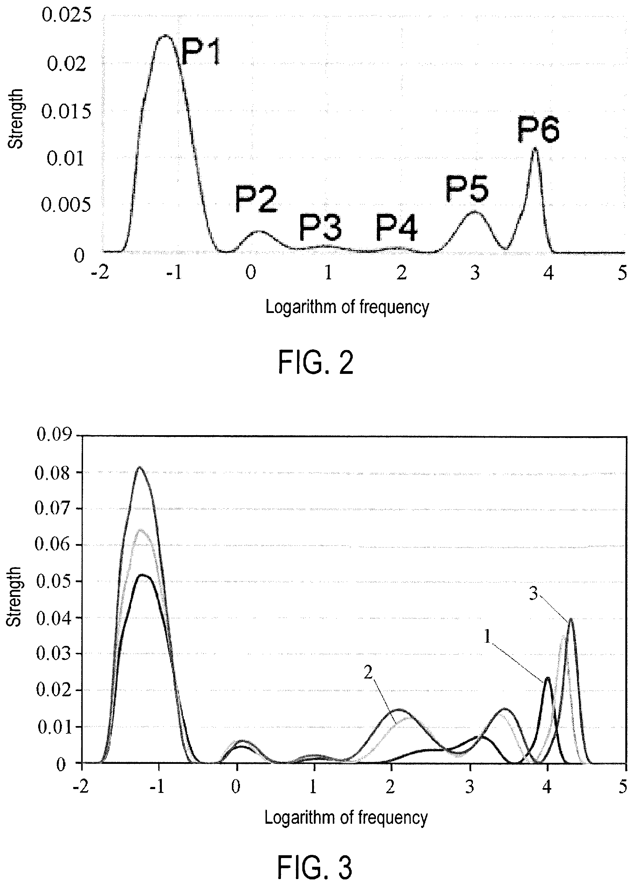

In some embodiments, the DRT spectrum can be provided as shown in FIG. 2. The curve shown in FIG. 2 has 6 peaks, and impedance types corresponding to the peaks from left to right are a solid phase diffusion impedance, a liquid phase diffusion impedance, a negative charge transfer impedance, a positive charge transfer impedance, a membrane impedance, and a contact impedance.

Certainly, in actual situations, the number of peaks in the curve in the DRT spectrogram is not limited to 6. The number of peaks may be less than 6 or more than 6, depending on the actual situation, and this is only shown in FIG. 2 as an example for illustration.

Based on the above, in some embodiments, the implementation process of the above S102 may include the following step.

When each peak among the plurality of peaks corresponds to one impedance, the peak parameter(s) of the corresponding peak(s) of the membrane impedance and/or the contact impedance in the DRT spectrogram is/are determined.

That is, as shown in FIG. 2, if the six peaks are numbered from left to right, such as P1, P2, P3, P4, P5, and P6, the peak parameter of peak P5 and/or the peak parameter of peak P6 can be determined.

In this way, by parameterizing the internal impedance of the battery corresponding to the peaks P5 and P6, the change of the internal impedance of the battery can be determined through the peak parameters.

Certainly, in actual situations, the battery state of health is not limited to be determined based on the peak parameters of the peak P5 and/or the peak P6, and the battery state of health may also be determined based on the peak parameters of the peak P1, the peak P2, the peak P3, and/or the peak P4. The specific implementation may be determined according to the actual situation to meet the needs of different application scenarios.

In S103, deviations of the determined peak parameters from peak parameters of corresponding peaks in a DRT spectrogram corresponding to a reference power battery are calculated.

In some embodiments, the reference power battery is the power battery when it leaves the factory or a power battery with same performance parameters as the power battery and a number of charging and discharging cycles less than 10. Herein, the number of charging and discharging cycles is not limited to 10 and can also be set to 5 or 15 times, but this number should not be set to be excessively large, so as to avoid inaccurate subsequent detection results due to attenuation of the reference power battery.

Further, the power battery may be a power battery that is formally used after leaving the factory, and the reference power battery may be a power battery with good battery state of health and no capacity loss. In this way, by comparing with the reference power battery, it is possible to determine the offsets of the peak parameters of the power battery in the process of leaving the factory to reflect capacity loss rates, so that the battery state of health of the power battery can be subsequently detected.

In some embodiments, taking the at least some peaks in S102 as one peak, the peak being a peak corresponding to the membrane impedance, and the peak parameter of the corresponding peak of the membrane impedance being determined in S102 as an example, and the specific implementation of the above S103 includes the following step.

If the peak parameter is the peak frequency, the deviation of the peak frequency of the corresponding peak of the membrane impedance of the power battery from the peak frequency of the corresponding peak of the membrane impedance in the DRT spectrogram corresponding to the reference power battery is calculated.

If the peak parameter is the integrated area of a peak, the deviation of the integrated area of the corresponding peak of the membrane impedance of the power battery from the integrated area of the corresponding peak of the membrane impedance in the DRT spectrogram corresponding to the reference power battery is calculated.

In this way, no matter how many peaks the at least some peaks in S102 are, the deviation corresponding to the peak parameter can be determined, so that the battery state of health of the power battery can be subsequently detected.

For instance, as shown in FIG. 3, the figure shows the DRT spectra at three different capacity loss rates. It can be seen from the figure that the peak parameters of the peak P4, the peak P5, and the peak P6 corresponding to different capacity loss rates are quite different. Assuming that curve 1 is the curve corresponding to the reference power battery, the deviations of the peak parameters of the peak P4, the peak P5, and the peak P6 in a curve 2 and in a curve 4 can be calculated, and the deviations of the peak parameters of the peak P4, the peak P5, and the peak P6 in a curve 3 and in a curve 1 can be calculated.

In S104, capacity loss rates corresponding to the calculated deviations are determined according to a corresponding relationship between a predetermined deviation and the capacity loss rate of each peak.

In some embodiments, the corresponding relationship may be, but not limited to, as shown in Table 1.

Table 1

| Capacity Loss Rate | Deviation of Each Peak | | | | | |
|---|---|---|---|---|---|---|
| | Peak P1 | Peak P2 | Peak P3 | Peak P4 | Peak P5 | Peak P6 |
| k1 | $\triangle x1$ | $\triangle x2$ | $\triangle x3$ | $\triangle x4$ | $\triangle x5$ | $\triangle x6$ |
| k2 | $\triangle x7$ | $\triangle x8$ | $\triangle x9$ | $\triangle x10$ | $\triangle x11$ | $\triangle x12$ |
| k3 | $\triangle x13$ | $\triangle x14$ | $\triangle x15$ | $\triangle x16$ | $\triangle x17$ | $\triangle x18$ |

It can be seen from Table 1 above that the peaks correspond to different deviations at different capacity loss rates, so when the deviation of a specific peak is determined, the capacity loss rate corresponding to the deviation of the peak can be found from Table 1. For instance, if the peak parameter of the peak P4 is determined in S102, the deviation of the peak P4 is calculated in S103. Assuming that the deviation of the peak P4 is $\triangle x10$, then the corresponding capacity loss rate found in Table 1 is k2.

In some embodiments, the corresponding relationship may also satisfy the following formula (i.e., Formula 1):

$$k=a*\triangle Vi+b,$$

where when the plurality of peaks are numbered in sequence, i represents the number of a peak, $\triangle Vi$ represents the deviation corresponding to an $i^{th}$ peak, k represents the capacity loss rate, $a \in [-200, 0)$, and $b \in [0, 200]$. When the peak parameter is the peak frequency, $\triangle Vi$ may be replaced by $\triangle \log(fi)$. When the peak parameter is the integrated area of a peak, $\triangle Vi$ may be replaced by $\triangle Si$, and S represents the integrated area.

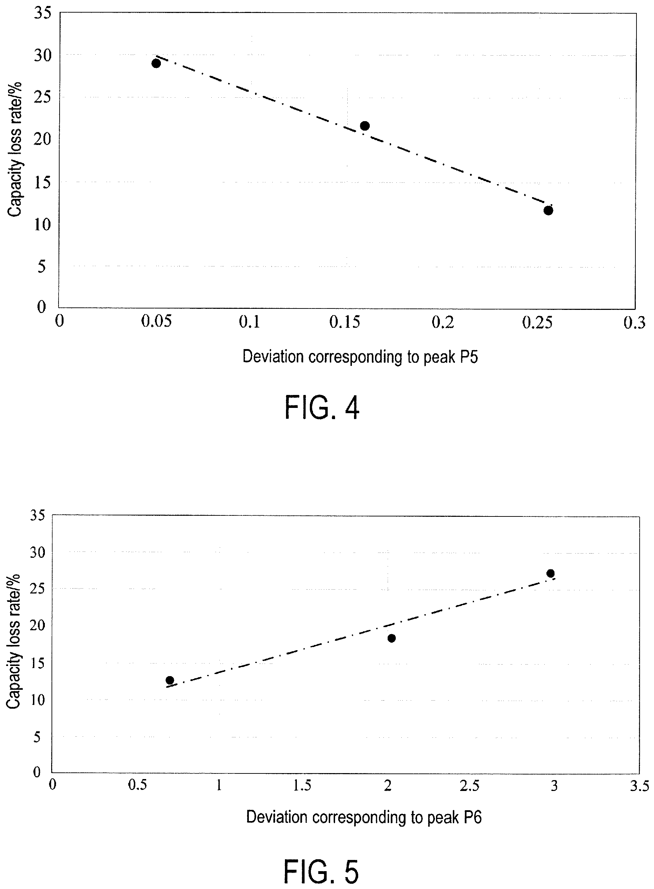

FIG. 4 is a relationship curve between the deviation (i.e., $\triangle \log(f5)$) and the capacity loss rate corresponding to the peak P5 when the peak parameter is the peak frequency, and FIG. 5 is a relationship curve between the deviation (i.e., $\triangle S6$) and the capacity loss rate corresponding to the peak P6 when the peak parameter is the integrated area of the peak. Herein, the deviation and the capacity loss rate have a linear relationship, which conforms to the relationship between the deviation and the capacity loss rate in Formula 1.

In this way, through Formula 1, the capacity loss rate corresponding to the determined deviation of each peak may be calculated, and that the battery state of health of the power battery may thus be further determined.

In addition, the type of power battery to which Formula 1 is applicable is not limited to: a ternary lithium battery or an iron-lithium battery.

Certainly, the corresponding relationship is not limited to the form given by Formula 1, and may also be other forms satisfying the corresponding relationship between the deviation and the capacity loss rate, which are not limited herein.

In some embodiments, the corresponding relationship may be pre-established and pre-implanted into a storage space of a device, and when the device needs to detect the battery state of health, the corresponding relationship may be called from the storage space.

The method for determining the corresponding relationship includes the following steps.

A sample power battery is selected.

An electrochemical impedance test is performed on the sample power battery, DRT processing is performed on test data, and a corresponding DRT spectrogram is then obtained. Further, a peak parameter of each peak is extracted from the spectrum and treated as an initial peak parameter of each peak, and a current capacity of the sample power battery is determined and treated as an initial capacity.

A working condition of the sample power battery is aged, and the peak parameters of the peaks under different capacities are obtained.

Deviations of the peak parameters of the peaks at different capacities from the initial peak parameters of the corresponding peaks are calculated.

According to the initial capacity, the capacity loss rates corresponding to different capacities are calculated.

A corresponding relationship between the deviation and the capacity loss rate of each peak is established.

Herein, a plurality of sample power batteries may be selected, and the sample power batteries may be subjected to a variety of aging processes under different working conditions, so that the capacity loss under different working conditions may be simulated. In this way, the corresponding relationship may be applied to various application scenarios, and rapid and accurate detection of the battery state of health may be achieved in various application scenarios.

In S105, the battery state of health of the power battery is determined according to the determined capacity loss rates.

In some embodiments, implementation of S105 includes the following steps.

When the at least some peaks is one peak and the determined capacity loss rate is 1 capacity loss rate in S102, the battery state of health of the power battery is converted according to the determined capacity loss rate.

When the at least some peaks are multiple peaks (e.g., n peaks, and n is an integer greater than 1) and the determined capacity loss rates are n capacity loss rates, an average value of the determined capacity loss rates are calculated, and the battery state of health of the power battery is converted according to the average value.

Certainly, when n capacity loss rates are provided, the calculation of the battery state of health is not limited to the average value of the capacity loss rates and may be set as follows.

Based on the minimum value of the capacity loss rates, the battery state of health of the power battery is converted.

Alternatively, based on the maximum value of the capacity loss rates, the battery state of health of the power battery is converted.

In this way, when the capacity loss rate is 1 capacity loss rate, it means that the peak parameter of one peak is determined in S102. In this way, after the processing of S103 and S104, one capacity loss rate can be obtained, and the battery state of health of the power battery can then be converted directly based on the capacity loss rate. When the capacity loss rates are n capacity loss rates, it means that the peak parameters of plural peaks are determined in S102. In this way, after the processing of S103 and S104, multiple capacity loss rates can be obtained, and the battery state of health of the power battery can then be converted after simple mathematical processing is performed on the multiple capacity loss rates. Therefore, this method may be applied to various application scenarios, and when n capacity loss rates are provided, the accuracy of the detection result is improved, and errors are reduced.

In some embodiments, when the battery state of health is converted based on the capacity loss rate, the following is included.

The value of 100% minus the capacity loss rate is treated as the battery state of health.

For instance, when the capacity loss rate is 20%, the converted battery state of health may be 80%.

In this way, when the DRT spectrum of the power battery is obtained, the peak parameters may be determined from peak information given by the DRT spectrum. The deviation may be obtained by making a difference with the peak parameter of the corresponding peak in the reference power battery. Through the deviation, the corresponding capacity loss rate may be found from the corresponding relationship between the deviation and the capacity loss rate of each peak. Based on the found capacity loss rate, the battery state of health is determined. In this way, the battery state of health of the power battery may be quickly and accurately detected, and data reference may be provided for the use of the power battery.

In some embodiments, the above process from S101 to S105 may be performed periodically. For instance, execution is performed according to a set detection period, a timer is set, and the above process from S101 to S105 is executed when the timer reaches the detection period, so that the detection of the battery state of health can be achieved to determine whether the power battery can continue to be used. Herein, the length of the detection period may be set according to factors such as the application scenario, capacity, and detection needs of the power capacitor, and it is not limited herein.

Alternatively, the processes from S101 to S105 may also be performed according to user needs. For instance, a detection button is set in an apparatus equipped with a power battery, and when the user wants to detect the battery state of health, the user can click the detection button, so that the device enters a detection program. In this way, the battery state of health is detected, and the user may know the performance of the power battery.

Based on the same inventive concept, the disclosure further provides a device for detecting a battery state of health. The implementation principle of the device is similar to that of the foregoing method, so description of the specific implementation of the device may be found with reference to the specific embodiments of the foregoing method and thus is not repeated herein.

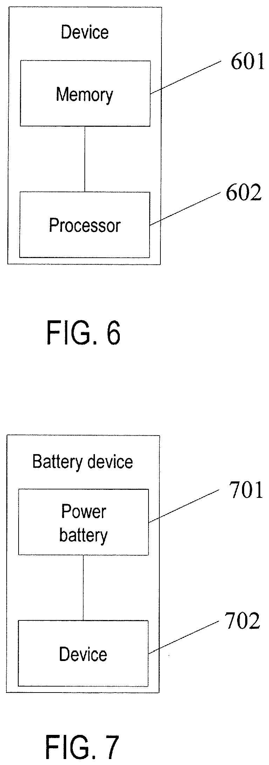

To be specific, an embodiment of the disclosure provides a device for detecting a battery state of health, and as shown in FIG. 6, the device includes a memory 601 and a processor 602.

The memory 601 is configured to store a program instruction.

The processor 602 is configured to call the program instruction stored in the memory 601 and execute the following processes according to an obtained program.

When an electrochemical impedance test is performed on a power battery and test data is obtained, DRT processing is performed on the test data, and a DRT spectrogram is obtained.

Peak parameters of at least some peaks among a plurality of peaks of the DRT spectrogram are determined, and the peak parameters include a peak frequency and/or an integrated area of a peak.

Deviations of the determined peak parameters from peak parameters of corresponding peaks in a DRT spectrogram corresponding to a reference power battery are calculated.

Capacity loss rates corresponding to the calculated deviations are determined according to a corresponding relationship between a predetermined deviation and the capacity loss rate of each peak.

The battery state of health of the power battery is determined according to the determined capacity loss rates.

In some embodiments, the processor is configured to performed the following.

When each peak among the plurality of peaks corresponds to one impedance, the peak parameter(s) of the corresponding peak(s) of the membrane impedance and/or the contact impedance in the DRT spectrogram is/are determined.

In some embodiments, the processor is configured to performed the following.

When the at least some peaks is one peak and the determined capacity loss rate is 1 capacity loss rate, the battery state of health of the power battery is converted according to the determined capacity loss rate.

When the at least some peaks are multiple peaks and the determined capacity loss rates are multiple capacity loss rates, an average value of the determined capacity loss rates are calculated, and the battery state of health of the power battery is converted according to the average value.

In some embodiments, the processor is further configured to performed the following.

A corresponding relationship between the deviation and the capacity loss rate of each peak is established.

Based on the same inventive concept, an embodiment of the disclosure further provides a battery device, and as shown in FIG. 7, the battery device includes a power battery 701 and a device 702 as provided in the embodiments of the disclosure.

In some embodiments, the device may be but not limited to a battery management system.

In some embodiments, when the power battery is a single battery or a battery apparatus, the battery device may be a battery pack, and when the power battery is a battery pack, the battery device may be an integrated energy storage system.

In some embodiments, in addition to the power battery and the device, the battery device may also include other structures for implementing the functions of the battery device, which is not limited herein.

It will be apparent to those skilled in the art that various modifications and variations can be made to the disclosure without departing from the scope of the disclosure. In view of the foregoing, it is intended that the disclosure covers modifications and variations provided that they fall within the scope of the following claims.

## Claims

1. A method for detecting a battery state of health, comprising performing distribution of relaxation times, DRT,

   processing on test data and obtaining a DRT spectrogram when performing an electrochemical impedance test on a power battery and obtaining the test data (S101);
   determining peak parameters of at least some peaks among a plurality of peaks of the DRT spectrogram, wherein the peak parameters comprise a peak frequency and/or an integrated area of a peak (S102); wherein the method is **characterised by**
   calculating deviations of the determined peak parameters from peak parameters of corresponding peaks in a DRT spectrogram corresponding to a reference power battery (S103);
   determining a capacity loss rate corresponding to the calculated deviations according to a corresponding relationship between a predetermined deviation and a predetermined capacity loss rate of each of the plurality of peaks (S104); and
   determining the battery state of health of the power battery according to the determined capacity loss rate (S105).

2. The method according to claim 1, wherein the determining the peak parameters of the at least some peaks among the plurality of peaks of the DRT spectrogram comprises:
   determining the peak parameters of the corresponding peaks of a membrane impedance and/or a contact impedance in the DRT spectrogram when each peak among the plurality of peaks corresponds to one impedance.

3. The method according to claim 1, wherein the determining the battery state of health of the power battery according to the determined capacity loss rate comprises:

   converting the battery state of health of the power battery according to the determined capacity loss rate when the at least some peaks is one peak and the determined capacity loss rates is one capacity loss rate; and
   calculating an average value of the determined capacity loss rates when the at least some peaks are multiple peaks and the determined capacity loss rate are multiple capacity loss rates and converting the battery state of health of the power battery according to the average value.

4. The method according to claim 1, wherein the reference power battery is the power battery when leaving the factory or a power battery with same performance parameters as the power battery and a number of charging and discharging cycles less than 10.

**5.** The method according to any one of claims 1 to 4, wherein the corresponding relationship satisfies the following formula:

$$k=a*\triangle Vi+b,$$

wherein when numbering the plurality of peaks in sequence, i represents the number of a peak, $\Delta Vi$ represents the deviation corresponding to an $i^{th}$ peak, k represents the capacity loss rate, $a\in[-200, 0)$, and $b\in[0, 200]$.

**6.** A device for detecting a battery state of health, comprising:

a memory (601), configured to store a program instruction; and
a processor (602), configured to call the program instruction stored in the memory and execute the following process according to the program instruction;
performing distribution of relaxation times, DRT, processing on test data and obtaining a DRT spectrogram when performing an electrochemical impedance test on a power battery and obtaining the test data;
determining peak parameters of at least some peaks among a plurality of peaks of the DRT spectrogram, wherein the peak parameters comprise a peak frequency and/or an integrated area of a peak; wherein the device is **characterised by**
calculating deviations of the determined peak parameters from peak parameters of corresponding peaks in a DRT spectrogram corresponding to a reference power battery;
determining a capacity loss rate corresponding to the calculated deviations according to a corresponding relationship between a predetermined deviation and a predetermined capacity loss rate of each of the plurality of peaks; and
determining the battery state of health of the power battery according to the determined capacity loss rate.

**7.** The device according to claim 6, wherein the processor is configured to:
determine the peak parameters of the corresponding peaks of a membrane impedance and/or a contact impedance in the DRT spectrogram when each peak among the plurality of peaks corresponds to one impedance.

**8.** The device according to claim 6, wherein the processor is configured to:

convert the battery state of health of the power battery according to the determined capacity loss rate when the at least some peaks is one peak and the determined capacity loss rate is one capacity loss rate; and
calculate an average value of the determined capacity loss rate when the at least some peaks are multiple peaks and the determined capacity loss rate are multiple capacity loss rates and convert the battery state of health of the power battery according to the average value.

**9.** The device according to any one of claims 6 to 8, wherein the processor is further configured to:
establish a corresponding relationship between the deviation and the capacity loss rate of each of the plurality of peaks.

**10.** A battery device, **characterized by** comprising a power battery (701) and the device (702) according to any one of claims 6 to 9.

**Patentansprüche**

**1.** Erfassungsverfahren eines Batterie-Gesundheitszustands, das umfasst

Durchführen einer Verteilung der Relaxationszeit, DRT, Verarbeitung an Testdaten und Erhalten eines DRT-Spektrogramms bei Durchführung eines elektrochemischen Impedanztests an einer Leistungsbatterie und Erhalten der Testdaten (S101);
Bestimmen von Spitzenwertparametern von wenigstens einigen Spitzenwerten unter einer Vielzahl von Spitzenwerten des DRT-Spektrogramms, wobei die Spitzenwertparameter eine Spitzenwertfrequenz und/oder eine integrierte Fläche eines Spitzenwerts umfassen (S102); wobei das Verfahren **gekennzeichnet ist, durch**
Berechnen von Abweichungen der bestimmten Spitzenwertparameter von Spitzenwertparametern entsprechender Spitzenwerte in einem DRT-Spektrogramm, das einer Referenz-Leistungsbatterie entspricht (S103);

Bestimmen einer Kapazitätsverlustrate entsprechend den berechneten Abweichungen gemäß einer entsprechenden Beziehung zwischen einer vorbestimmten Abweichung und einer vorbestimmten Kapazitätsverlustrate jedes der mehreren Spitzenwerte (S104); und

Bestimmen des Batterie-Gesundheitszustands der Leistungsbatterie gemäß der bestimmten Kapazitätsverlustrate (S105).

2. Verfahren gemäß Anspruch 1, wobei das Bestimmen der Spitzenwertparameter der wenigstens einigen Spitzenwerte unter der Vielzahl von Spitzenwerten des DRT-Spektrogramms umfasst:

Bestimmen der Spitzenwertparameter der entsprechenden Spitzenwerte einer Membranimpedanz und/oder einer Kontaktimpedanz in dem DRT-Spektrogramm, wenn jeder Spitzenwert aus der Vielzahl von Spitzenwerten einer Impedanz entspricht.

3. Verfahren gemäß Anspruch 1, wobei das Bestimmen des Batterie-Gesundheitszustands der Leistungsbatterie gemäß der vorbestimmten Kapazitätsverlustrate umfasst:

Umwandeln des Batterie-Gesundheitszustands der Leistungsbatterie gemäß der vorbestimmten Kapazitätsverlustrate, wenn die wenigstens einigen Spitzenwerte ein Spitzenwert ist und die vorbestimmte Kapazitätsverlustrate eine Kapazitätsverlustrate ist; und

Berechnen eines Durchschnittswerts der vorbestimmten Kapazitätsverlustraten, wenn die wenigstens einigen Spitzenwerte mehrere Spitzenwerte sind und die vorbestimmte Kapazitätsverlustrate mehrere Kapazitätsverlustraten sind, und Umwandeln des Batterie-Gesundheitszustands der Leistungsbatterie entsprechend dem Durchschnittswert.

4. Verfahren gemäß Anspruch 1, wobei die Referenzleistungsbatterie die Leistungsbatterie beim Verlassen des Werks oder eine Leistungsbatterie mit denselben Leistungsparametern wie die Leistungsbatterie und einer Anzahl von Lade- und Entladezyklen von weniger als 10 ist.

5. Verfahren gemäß einem der Ansprüche 1 bis 4, wobei die entsprechende Beziehung die folgende Formel erfüllt:

$$k = a * \triangle V_i + b,$$

wobei, beim Beziffern der Vielzahl von Spitzenwerte in Reihenfolge, i die Anzahl eines Spitzenwerts darstellt, $\triangle V_i$ die Abweichung entsprechend eines i$^{ten}$ Spitzenwerts darstellt, k die Kapazitätsverlustrate, $a \in [-200 , 0)$, und $b \in [0 , 200]$ darstellt.

6. Erfassungsvorrichtung eines Batterie-Gesundheitszustands, umfassend:

einen Speicher (601), der zum Speichern einer Programmbefehlssequenz konfiguriert ist; und
einen Prozessor (602), der zum Aufrufen der Programmbefehlssequenz, gespeichert in dem Speicher, und zum Ausführen des folgenden Prozesses gemäß der Programmbefehlssequenz konfiguriert ist:

Durchführen einer Verteilung der Relaxationszeit, DRT, Verarbeitung an Testdaten und Erhalten eines DRT-Spektrogramms, wenn ein elektrochemischer Impedanztest an einer Leistungsbatterie durchgeführt wird und die Testdaten erhalten werden;
Bestimmen von Spitzenwertparametern von wenigstens einigen Spitzenwerten aus einer Vielzahl von Spitzenwerten des DRT-Spektrogramms, wobei die Spitzenwertparameter eine Spitzenwertfrequenz und/oder eine integrierte Fläche eines Spitzenwerts umfassen; wobei die Vorrichtung **gekennzeichnet ist, durch**
Berechnen von Abweichungen der vorbestimmten Spitzenwertparameter von Spitzenwertparametern entsprechender Spitzenwerte in einem DRT-Spektrogramm, das einer Referenzleistungsbatterie entspricht;
Bestimmen einer Kapazitätsverlustrate entsprechend den berechneten Abweichungen gemäß einer entsprechenden Beziehung zwischen einer vorbestimmten Abweichung und einer vorbestimmten Kapazitätsverlustrate jeder der Vielzahl von Spitzenwerten; und
Bestimmen des Batterie-Gesundheitszustands der Leistungsbatterie gemäß der vorbestimmten Kapazitätsverlustrate.

7. Vorrichtung gemäß Anspruch 6, wobei der Prozessor konfiguriert ist, um:

die Spitzenwertparameter der entsprechenden Spitzenwerte einer Membranimpedanz und/oder einer Kontaktimpedanz im DRT-Spektrogramm zu bestimmen, wenn jeder Spitzenwert aus der Vielzahl von Spitzenwerten einer Impedanz entspricht.

8. Vorrichtung gemäß Anspruch 6, wobei der Prozessor konfiguriert ist, um:

den Gesundheitszustand der Leistungsbatterie gemäß der vorbestimmten Kapazitätsverlustrate umzuwandeln, wenn die wenigstens einige Spitzenwerte ein Spitzenwert ist und die vorbestimmte Kapazitätsverlustrate eine Kapazitätsverlustrate ist; und
einen Durchschnittswert der vorbestimmten Kapazitätsverlustrate zu berechnen, wenn die mindestens einigen Spitzenwerte mehrere Spitzenwerte sind und die vorbestimmte Kapazitätsverlustrate mehrere Kapazitätsverlustraten sind, und
den Batterie-Gesundheitszustand der Leistungsbatterie gemäß dem Durchschnittswert umzuwandeln.

9. Vorrichtung gemäß einem der Ansprüche 6 bis 8, wobei der Prozessor ferner konfiguriert ist, um:
eine entsprechende Beziehung zwischen der Abweichung und der Kapazitätsverlustrate jedes der Vielzahl von Spitzenwerten herzustellen.

10. Batterievorrichtung, **dadurch gekennzeichnet, dass** sie eine Leistungsbatterie (701) und die Vorrichtung (702) gemäß einem der Ansprüche 6 bis 9 umfasst.

## Revendications

1. Procédé permettant de détecter l'état de santé d'une batterie, comprenant

la réalisation d'un traitement de distribution des temps de relaxation, DRT, sur des données de test et l'obtention d'un spectrogramme DRT lors de la réalisation d'un test d'impédance électrochimique sur une batterie d'alimentation et l'obtention des données de test (S101) ;
la détermination des paramètres de crête d'au moins certaines crêtes parmi une pluralité de crêtes du spectrogramme DRT, dans lequel les paramètres de crête comprennent une fréquence de crête et/ou une aire intégrée d'une crête (S102) ; dans lequel le procédé est **caractérisé par**
le calcul des écarts des paramètres de crête déterminés par rapport aux paramètres de crête des crêtes correspondantes dans un spectrogramme DRT correspondant à une batterie d'alimentation de référence (S103) ;
la détermination d'un taux de perte de capacité correspondant aux écarts calculés selon une relation correspondante entre un écart prédéterminé et un taux de perte de capacité prédéterminé de chacun des pics de la pluralité de pics (S104) ; et
la détermination de l'état de santé de la batterie d'alimentation en fonction de la perte de capacité déterminée (S105).

2. Procédé selon la revendication 1, dans lequel la détermination des paramètres de crête d'au moins certaines crêtes parmi la pluralité de crêtes du spectrogramme DRT comprend :
la détermination des paramètres de crête des crêtes correspondantes d'une impédance de membrane et/ou d'une impédance de contact dans le spectrogramme DRT lorsque chaque crête parmi la pluralité de crêtes correspond à une impédance.

3. Procédé selon la revendication 1, dans lequel la détermination de l'état de charge de la batterie d'alimentation en fonction du taux de perte de capacité déterminé comprend :

la conversion de l'état de charge de la batterie d'alimentation en fonction du taux de perte de capacité déterminé lorsque les au moins quelques pics sont un pic et que les taux de perte de capacité déterminés sont un taux de perte de capacité ; et
le calcul d'une valeur moyenne des taux de perte de capacité déterminés lorsque les au moins quelques pics sont des pics multiples et que les taux de perte de capacité déterminés sont des taux de perte de capacité multiples, et
la conversion de l'état de charge de la batterie d'alimentation en fonction de la valeur moyenne.

4. Procédé selon la revendication 1, dans lequel la batterie d'alimentation de référence est la batterie d'alimentation à sa sortie d'usine ou une batterie d'alimentation ayant les mêmes paramètres de performance que la batterie d'alimentation et un nombre de cycles de charge et de décharge inférieur à 10.

5.  Procédé selon l'une quelconque des revendications 1 à 4, dans lequel la relation correspondante satisfait la formule suivante :

$$k = a * \Delta Vi + b,$$

dans laquelle, lorsque l'on numérote les multiples pics dans l'ordre, i représente le numéro d'un pic, $\Delta Vi$ représente l'écart correspondant à un ième pic, k représente le taux de perte de capacité, $a\varepsilon$ [-200, 0] et $b\varepsilon$ [0, 200].

6.  Dispositif permettant de détecter l'état de charge d'une batterie, comprenant :

    une mémoire (601) configurée pour stocker une instruction de programme ; et
    un processeur (602), configuré pour appeler l'instruction de programme stockée dans la mémoire et exécuter le processus suivant conformément à l'instruction de programme ;
    la réalisation d'un traitement de distribution des temps de relaxation, DRT, sur des données de test et l'obtention d'un spectrogramme DRT lors de la réalisation d'un test d'impédance électrochimique sur une batterie d'alimentation et l'obtention des données de test ;
    la détermination des paramètres de crête d'au moins certaines crêtes parmi une pluralité de crêtes du spectrogramme DRT, dans lequel les paramètres de crête comprennent une fréquence de crête et/ou une aire intégrée d'une crête ; dans lequel le dispositif est **caractérisé par**
    le calcul des écarts des paramètres de crête déterminés par rapport aux paramètres de crête des crêtes correspondantes dans un spectrogramme DRT correspondant à une batterie d'alimentation de référence ;
    la détermination d'un taux de perte de capacité correspondant aux écarts calculés selon une relation correspondante entre un écart prédéterminé et un taux de perte de capacité prédéterminé de chacun des pics de la pluralité de pics ; et
    la détermination de l'état de charge de la batterie d'alimentation en fonction du taux de perte de capacité déterminé.

7.  Dispositif selon la revendication 6, dans lequel le processeur est configuré pour :
    déterminer les paramètres de crête des pics correspondants d'une impédance de membrane et/ou d'une impédance de contact dans le spectrogramme DRT lorsque chacun des pics parmi la pluralité de pics correspond à une impédance.

8.  Dispositif selon la revendication 6, dans lequel le processeur est configuré pour :

    convertir l'état de charge de la batterie d'alimentation en fonction du taux de perte de capacité déterminé lorsque les au moins quelques pics sont un pic et que le taux de perte de capacité déterminé est un taux de perte de capacité ; et
    calculer une valeur moyenne du taux de perte de capacité déterminé lorsque les au moins quelques pics sont plusieurs pics et que les taux de perte de capacité déterminés sont plusieurs taux de perte de capacité, et convertir l'état de charge de la batterie d'alimentation en fonction de la valeur moyenne.

9.  Dispositif selon l'une quelconque des revendications 6 à 8, dans lequel le processeur est en outre configuré pour :
    établir une relation correspondante entre l'écart et le taux de perte de capacité de chacun des multiples pics.

10. Dispositif de batterie, **caractérisé en ce qu'**il comprend une batterie d'alimentation (701) et le dispositif (702) selon l'une quelconque des revendications 6 à 9.

Performing distribution of relaxation times (DRT) processing on test data and obtaining a DRT spectrogram when performing an electrochemical impedance test on a power battery and obtaining the test data — S101

Determining peak parameters of at least some peaks among a plurality of peaks of the DRT spectrogram, wherein the peak parameters comprise a peak frequency and/or an integrated area of a peak — S102

Calculating deviations of the determined peak parameters from peak parameters of corresponding peaks in a DRT spectrogram corresponding to a reference power battery — S103

Determining capacity loss rates corresponding to the calculated deviations according to a corresponding relationship between a predetermined deviation and the capacity loss rate of each peak — S104

Determining a battery state of health of the power battery according to the determined capacity loss rates — S105

FIG. 1

FIG. 2

FIG. 3

FIG. 4

FIG. 5

Device

Memory — 601

Processor — 602

## FIG. 6

Battery device

Power battery — 701

Device — 702

## FIG. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 115356640 A